# EUROPÄISCHE PATENTANMELDUNG

(11) **EP 4 087 088 A1**
(43) Veröffentlichungstag der Anmeldung: **09.11.2022**
(21) Anmeldenummer: 21172258.2
(22) Anmeldetag: 05.05.2021
(51) Int. Cl.: H02J 13/00, G01R 19/25, H02J 3/00

(54) **ANORDNUNG UND VERFAHREN ZUR STEUERUNG EINES ELEKTRISCHEN ENERGIENETZES**

(71) Anmelder: Siemens Aktiengesellschaft, 80333 München (DE)
(72) Erfinder: Heyde, Chris Oliver, 91058 Erlangen (DE); Wiest, Pascal, 90478 Nürnberg (DE)

(57) **Zusammenfassung**

Gegenstand der vorliegenden Erfindung ist eine Anordnung zur Steuerung eines elektrischen Energienetzes mit zwei Teilnetzen,
mit einer ersten Steuereinrichtung für ein erstes Teilnetz, die ausgebildet ist, anhand eines Netzmodells des ersten Teilnetzes eine erste Zustandsschätzung für das erste Teilnetz zu erstellen, um anhand der ersten Zustandsschätzung Steuerbefehle an steuerbare Betriebsmittel des ersten Teilnetzes zu erstellen und zu senden, so dass ein erstes Steuerungsziel im ersten Teilnetz erreicht wird, und mit einer zweiten Steuereinrichtung für ein zweites Teilnetz, die ausgebildet ist, anhand eines Netzmodells des zweiten Teilnetzes eine zweite Zustandsschätzung für das zweite Teilnetz zu erstellen, um mittels der zweiten Zustandsschätzung Steuerbefehle an steuerbare Betriebsmittel des zweiten Teilnetzes zu erstellen und zu senden, so dass ein zweites Steuerungsziel im zweiten Teilnetz erreicht wird,
dadurch gekennzeichnet, dass
die erste Steuereinrichtung ausgebildet ist, mittels einer ersten Kommunikationseinrichtung ein Datentelegramm mit dem ersten Netzmodell über eine Datenkommunikationsverbindung an die zweite Steuereinrichtung zu senden,
und dass
die zweite Steuereinrichtung ausgebildet ist, mittels einer zweiten Kommunikationseinrichtung das Datentelegramm zu empfangen und das erste Netzmodell in das zweite Netzmodell zu integrieren.

Ferner ist Gegenstand der vorliegenden Erfindung ein entsprechendes Verfahren.

## Beschreibung

Die vorliegende Erfindung betrifft eine Anordnung zur Steuerung eines elektrischen Energienetzes nach dem Oberbegriff des Anspruchs 1 sowie ein Verfahren nach dem Oberbegriff des Anspruchs 10.

Aus der Produktbroschüre "PSS®SINCAL All-in-one Simulation Software for the Analysis and Planning of Power Networks", Bestellnummer EMDG-B90038-00-7600, Siemens AG 2018, ist es von Seite 7 bekannt, ein Netzwerkmodell zur Planung und Analyse eines Energienetzes einzusetzen.

Die Bestimmung des Netzzustands erfolgt bisher zentral und ermöglicht eine Auslösung von Gegenmaßnahmen seitens einer zentralen Leitstelle, wenn z.B. zu große Abweichungen von der Nennspannung oder der Nennfrequenz gemessen werden. Es können Steuerbefehle an Netzregler, Schalter oder Stufensteller von Transformatoren, zwischen den Spannungsebenen Niederspannung im Verteilnetz, Mittelspannung und Hochspannung, ausgesendet werden. Dabei ist es beispielsweise von Wikipedia (permanenter Link https://de.wikipedia.org/w/index.php?title=Lastflussberechnun g&oldid=184195685) und aus der Veröffentlichung "Berechnung elektrischer Energienetze", TU Graz 2017, von S. Polster und H. Renner, Seiten 12-21, bekannt, einen Systemzustand eines elektrischen Energienetzes anhand einer Lastflussberechnung abzuschätzen. Dabei werden u.a. eine Admittanzmatrix und eine Jacobi-Matrix zur Lösung eingesetzt.

Bei dezentralen Ansätzen zur Steuerung von Energienetzen ist es bekannt, Fernwirkgeräte (sog. Remote Terminal Units, RTUs) mit lokaler Intelligenz und Steuerungsmöglichkeiten auszustatten. Beispielsweise ist die RTU "SICAM A8000 Serie Steuern, Fernwirken und Automatisieren auf kleinstem Raum", Bestellnummer EMDG-B10037-01, Siemens AG 2016, bekannt.

Beispielsweise kann eine RTU bisher bei Erkennung einer starken Abweichung der Netzfrequenz von einer Sollvorgabe automatisiert Steuerbefehle aussenden, um einzelne Verbraucher abzuschalten ("load scheddding").

Ausgehend von bisherigen Anordnungen zur Steuerung eines elektrischen Energienetzes stellt sich an die Erfindung die Aufgabe, eine Anordnung anzugeben, mit dem zwei Teilnetze eines Energienetzes besonders sicher und einfach dezentral gesteuert werden können.

Die Erfindung löst diese Aufgabe durch eine Anordnung gemäß Anspruch 1.

Ein Netzwerkmodell umfasst dabei z.B. zumindest eine Admittanzmatrix, ermittelt aus den Impedanzen aller Leitungen und Verbindungen zwischen Knoten, also der Topologie, eines Teilnetzes oder eines gesamten Energienetzes. Diese Informationen werden benötigt, um zusammen mit von Messeinrichtungen aus dem Energienetz empfangenen Messdaten wie z.B. Spannung, Stromstärke, Leistung und Blindleistung einen Netzzustand zu schätzen. Es können zusätzlich oder alternativ geschätzte Messwerte verwendet werden, wenn keine vollständigen Messdaten vorliegen. Der Netzzustand ist beispielsweise anhand von Lastflüssen im Teilnetz oder im gesamten Energienetz charakterisiert. Das zukünftige Verhalten hängt jeweils von den Stati und Parametern der Steuereinrichtungen (z.B. Feldgeräte) ab.

Ein Steuerungsziel ist z.B., dass keine Grenzwerte für Strom und Spannung oder Netzfrequenz im jeweiligen Teilnetz verletzt werden. Beispielsweise sind Abweichungen der Spannung von +/- 10 % der Nennspannung des Teilnetzes nicht zulässig. Ein Steuerungsziel kann auch beinhalten, dass es zu keinem Ausfall bzw. Blackout kommt.

Ein Feldgerät ist zum Einbau in einem Teilnetz vorgesehen und weist beispielsweise Prozessormittel und Datenspeichermittel sowie eine Kommunikationseinrichtung auf. Die Kommunikationseinrichtung ist beispielsweise zur Kommunikation über Funk (long range radio, GSM, 3G, 4G, 5G), per Kupfer-Kabel oder Lichtwellenleiter oder per sog. Powerline-Communication (PLC) über die Stromleitung ausgelegt. Als Kommunikationsprotokolle können beispielsweise IEC 61850 und/oder TCP/IP verwendet werden.

Ein Teilnetz umfasst beispielsweise Verbraucher und Erzeuger elektrischer Energie, und steuerbare Betriebsmittel wie z.B. Schaltanlagen und Transformatoren mit Stufensteller, Energiespeicher, Kondensatorbänke und Netzregler.

Eine Zustandsschätzung gibt beispielsweise Auskunft über erwartete Spannungs- und Stromwerte an allen oder ausgewählten Punkten des Energienetzes und erlaubt damit, Spannungsgrenzwert- oder Stromgrenzwertverletzungen aktuell zu erkennen. Die Zustandsschätzung kann auch vorab erfolgen, wenn zusätzlich prognostizierte Messwerte in die Schätzung einfließen.

Steuerbefehle sind beispielsweise analoge Signale oder digitale Datentelegramme, die einen Schaltbefehl an ein steuerbares Betriebsmittel beinhalten.

Das Datentelegramm mit dem ersten Netzmodell kann z.B. eine ausführbare Datei enthalten oder z.B. ein sog. "common information model" (CIM) nach dem Standard IEC 61970 umfassen, wie es aus der substation Kommunikation nach dem Standard IEC 61850 bekannt ist.

Die Integration des erstes Netzmodells in das zweite Netzmodell bedeutet beispielsweise, dass das zweite Netzmodell nun das erste Teilnetz in seinem elektrischen Verhalten näherungsweise beschreiben kann. Dies bedeutet, dass beispielsweise auch eine aggregierte Fassung des ersten Netzmodells verwendet werden kann, also z.B. eine vereinfachte Fassung. Dadurch sind beide Netzmodelle dahingehend synchronisiert, dass aus dem zweiten Netzmodell nicht versehentlich ein für das erste Teilnetz falscher Systemzustand abgeleitet wird, der in der Folge zu Schaltbefehlen und Schalthandlungen führen kann, die die Netzstabilität des ersten Teilnetzes oder des zweiten Teilnetzes gefährden.

In einer Weiterbildung dieses Ansatzes können auch beide Feldgeräte ihre jeweiligen Netzmodelle bidirektional austauschen, so dass beide jeweils über eine Kenntnis des Netzmodells des jeweils anderen Feldgeräts verfügen.

Die Netzsteuerung wird in Zukunft immer mehr automatisiert ablaufen. Um eine sog. N-1 Sicherheit zu gewährleisten, d.h. auch bei Ausfall einer einzelnen Komponente im Netzbetrieb weitere Abschaltungen oder größere Störungen zu vermeiden, müssen dezentral durch Feldgeräte selbsttätig Schalthandlungen durchgeführt werden. Es kann nicht oder nicht nur auf das Eingreifen von Bedienpersonal aus einer zentralen Leitstelle gewartet werden. Daher sollten solche Feldgeräte wie heute schon sog. "Microgrid-Controller" ein Teilnetz autonom optimieren und kontrollieren. Hierbei ergibt sich das Problem, dass in einem solchen Fall jedes Feldgerät für jedes Teilnetz ein eigenes Netzmodell aufweist, wobei das Netzmodell beispielsweise manuell durch einen Techniker konfiguriert oder aus Informationen einer Leitstelle vorkonfiguriert wurde.

Übermittelt ein Feldgerät den ermittelten Systemzustand und draus abgeleitete Schaltbefehle an ein weiteres Feldgerät mit einem anderen Netzmodell, so kann es unbemerkt zu falschen Schlüssen auf Seiten des weiteren Feldgeräts kommen, wenn die beiden verwendeten Netzmodelle sich beispielsweise widersprechen. Dies gilt besonders, wenn die beiden Feldgeräte in Teilnetzen unterschiedlicher Nennspannung angeordnet sind.

Wird wie erfindungsgemäß vorgeschlagen ein Netzmodell für eine Zustandsschätzung lokal in einem Feldgerät verwendet und stets anhand von aktuellen Messwerten aktualisiert, so kann beispielsweise auch dann ein Lastfluss im Teilnetz berechnet und die entsprechende Jacobi-Matrix einer Optimierungseinrichtung für die Netzsteuerung übergeben werden, wenn die zentrale Leitstelle nicht verfügbar ist. Beispielsweise könnte bei einem Störfall oder einem Hackerangriff die Kommunikation zwischen Feldgerät und Leitstelle und/oder zwischen der Leistelle und den steuerbaren Betriebsmitteln unterbrochen sein. Dann kann erfindungsgemäß das Feldgerät die Steuerung des Teilnetzes übernehmen, was die Verfügbarkeit und Verlässlichkeit des Energienetzes insgesamt erhöht. Das Netzmodell sollte zwischen allen Hierarchiestufen, also z.B. Feldgeräten der verschiedenen Spannungsebenen bis hin zur zentralen Leitstelle austauschbar bzw. kompatibel sein.

Grundsätzlich können zwei unterschiedliche Betriebsmodi für die Erfindung eingesetzt werden:
Entweder es wird als erste Steuereinrichtung die zentrale Leistelle eingesetzt, so dass das zentral angelegte Netzmodell "top-down" an alle unterlagerten zweiten Steuereinrichtungen bzw. Feldgeräte übermittelt wird,
oder es wird als erste Steuereinrichtung ein Feldgerät der niedrigsten Spannungsebene eingesetzt, und das Netzmodell über die Mittelspannungsebene hinauf bis zum zentralen Netzmodell der Leitstelle "bottom-up" aggregiert. Entsprechend kann bei einer komplexeren Hierarchie des Energieversorgungssystems mit mehreren Spannungsebenen mit jeweils einer Vielzahl von Teilnetzen auch erfindungsgemäß aggregiert werden.

In einer bevorzugten Ausführungsform weisen die zwei Teilnetze die gleiche Nennspannung aufweisen. Dies ist ein Vorteil, weil damit auch größere Energienetze wie Beispielsweise ein Mittelspannungsnetz in verschiedene Teilnetze aufgeteilt und dezentral gesteuert werden können.

Typischerweise weisen heute verbreitete Architekturen für Wechselspannungsnetze drei Spannungsebenen auf. Eine Niederspannungsebene mit z.B. bis zu 1 kV Nennspannung, die als Verteilnetz Verbraucher wie Einfamilienhäuser anbindet. Auch Erzeuger elektrischer Energie wie Photovoltaikanlagen können angeschlossen sein. Die Niederspannungsebene ist i.d.R. über Ortsnetztransformatoren mit einer Mittelspannungsebene mit z.B. 1 kV bis 52 kV Nennspannung verbunden. Die Mittelspannungsebene schließt beispielsweise ganze Städte oder Fabriken über entsprechende Transformatoren an das Hochspannungsnetz zur Energieübertragung mit einer Nennspannung von über 52 kV an.

In einer weiteren bevorzugten Ausführungsform ist die erste Steuereinrichtung ausgebildet, mittels einer ersten Kommunikationseinrichtung ein Datentelegramm mit ersten Netzregelungsinformationen über eine Datenkommunikationsverbindung an die zweite Steuereinrichtung zu senden, und die zweite Steuereinrichtung ist ausgebildet, mittels einer zweiten Kommunikationseinrichtung das Datentelegramm zu empfangen und die ersten Netzregelungsinformationen in zweite Netzregelungsinformationen zu integrieren. Eine Netzregelungsinformation umfasst beispielsweise eine mathematische Beschreibung bzw. Zusammenfassung eines Netzregelverhaltens, dass eine Steuereinrichtung für ein Teilnetz im Rahmen einer Optimierung auf ein Steuerungsziel hin und anhand eines Netzmodells ausbildet. Auch eine Übertragung einer Netzregelungsinformation kann daher für sich allein oder im Zusammenwirken mit einer Übertragung eines Netzmodells den erfindungsgemäßen Grundgedanken einer Synchronisierung der Steuerung von Teilnetzen verwirklichen.

In einer weiteren bevorzugten Ausführungsform weisen die zwei Teilnetze unterschiedliche Nennspannungen auf. Dies ist ein Vorteil, weil hiermit die Netzsteuerung dezentral zwischen den unterschiedlichen Spannungsebenen koordiniert werden kann.

In einer weiteren bevorzugten Ausführungsform sind die erste und/oder die zweite Steuereinrichtung als ein Feldgerät, Remote Terminal Unit, Schutzgerät oder Microgrid-Controller ausgebildet. Dies ist ein Vorteil, weil die genannten Geräte i.d.R. bereits mit ausreichender Rechenleistung ausgestattet sind, um ein Netzmodel zur Zustandsschätzung durchrechnen zu können.

In einer weiteren bevorzugten Ausführungsform weist das Netzmodell des ersten Teilnetzes eine Admittanzmatrix auf, die anhand von Impedanzwerten für Leitungen im ersten Teilnetz ermittelt ist. Dies ist ein Vorteil, weil mit der Admittanzmatrix auf einfache Weise ein Zustand geschätzt werden kann.

In einer weiteren bevorzugten Ausführungsform ist die Admittanzmatrix anhand einer Topologieinformation mit Leitungen und Knotenpunkten erstellt.

In einer weiteren bevorzugten Ausführungsform sind für die erste Zustandsschätzung Messwerte von Messeinrichtungen im ersten Teilnetz berücksichtigt. Als Messeinrichtungen können beispielsweise smart meter eingesetzt werden. Auch sog. Phasor Measurements Units können zur Messung mit kleiner zeitlicher Auflösung im ms-Bereich eingesetzt werden, wobei neben Spannungs- und Stromstärkewerten auch ein Phasenwinkel festgestellt werden kann.

In einer weiteren bevorzugten Ausführungsform beschreiben die Messwerte mindestens eine der folgenden elektrischen Messgrößen: Spannung, Stromstärke, elektrische Leistung, elektrische Blindleistung, Phasenwinkel.

In einer weiteren bevorzugten Ausführungsform sind die erste und/oder die zweite Steuereinrichtung ausgebildet, anhand der jeweiligen Zustandsschätzung mittels einer jeweiligen Optimierungseinrichtung Steuerbefehle an steuerbare Betriebsmittel des jeweiligen Teilnetzes zu erstellen und zu senden, so dass elektrische Verluste minimiert werden. Dies ist ein Vorteil, weil Kosten eingespart und die Umweltbelastung verringert wird.

Ausgehend von bisherigen Verfahren zur Steuerung eines elektrischen Energienetzes stellt sich an die Erfindung die Aufgabe, ein Verfahren anzugeben, mit dem zwei Teilnetze eines Energienetzes besonders sicher und einfach dezentral gesteuert werden können.

Die Erfindung löst diese Aufgabe durch ein Verfahren gemäß Anspruch 10. Es ergeben sich dabei für die erfindungsgemäße Anordnung und ihre bevorzugten Ausführungsformen gemäß den Unteransprüchen 11 bis 15 jeweils sinngemäß die gleichen Vorteile wie eingangs für die erfindungsgemäße Anordnung erläutert.

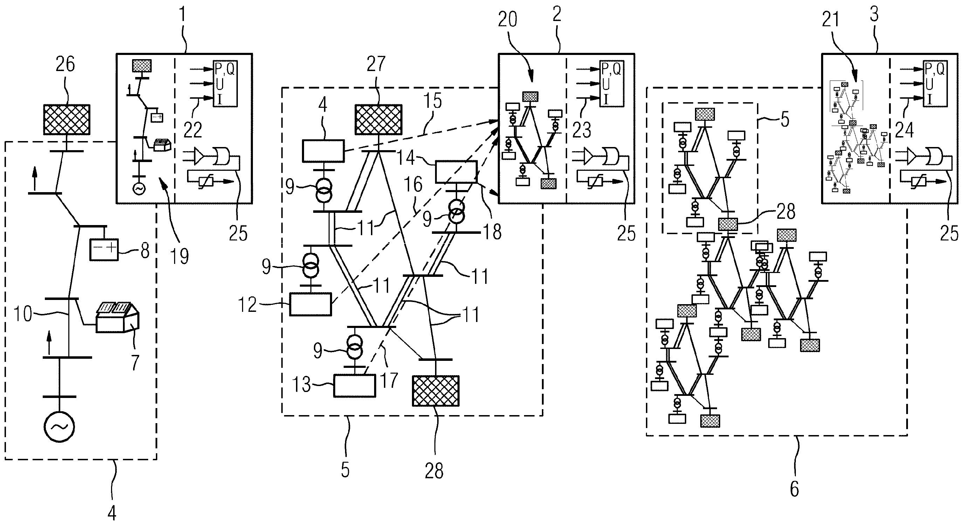

Zur besseren Erläuterung der Erfindung zeigt die Figur in schematischer Darstellung drei Teilnetze 4,5,6, die auf verschiedenen Spannungsebenen angesiedelt sind. Gleiche Komponenten sind jeweils mit den gleichen Bezugszeichen bezeichnet.

Das Teilnetz 4 ist ein Ortsnetz der Niederspannungsebene mit einer Niederspannungsleitung 10, einem Einfamilienhaus 7 und einem stationären Energiespeicher 8. Alternativ kann auch eine Ladeeinrichtung mit einem elektrischen angetriebenen Fahrzeug angeschlossen sein. Das Teilnetz 4 ist über einen Anschlusspunkt 26 mit einem übergeordneten Mittelspannungsnetz, dem Teilnetz 5, verbunden. Für das Teilnetz 4 ist ein Feldgerät 1 als erste Steuereinrichtung vorgesehen, das ein Netzmodell 19 des ersten Teilnetzes in seinem Datenspeicher (nicht dargestellt) bereithält, um eine erste Zustandsschätzung für das erste Teilnetz zu erstellen. Es werden Messwerte P,Q,U,I von Messeinrichtungen im ersten Teilnetz über Datenkommunikationspfade 22 eingespielt und ausgewertet. Anhand der ersten Zustandsschätzung werden vom Feldgerät 1 Steuerbefehle für steuerbare Betriebsmittel des ersten Teilnetzes erstellen, wobei ein Optimierungsverfahren oder ein Regelungsalgorithmus (angedeutet durch das Bezugszeichen 25), eingesetzt wird.

Die Steuerbefehle werden gesendet, so dass ein übergeordnetes Ziel der Steuerung im ersten Teilnetz erreicht wird. Beispielsweise sollen Grenzwertverletzungen für Spannung und Stromstärke vermieden werden.

Das Teilnetz 5 weist Transformatoren 9 auf, an die jeweils ein Ortsnetz 4,12,13,14 angeschlossen ist. Mittelspannungsleitungen 11 verbinden die verschiedenen Anschlusspunkte für die Ortsnetze 4,12,13,14. Das Teilnetz 5 ist über Anschlusspunkte 27,28 mit einem übergeordneten Hochspannungsnetz 5 verbunden.

Auch das Teilnetz 5 weist ein Feldgerät 2 als zweite Steuereinrichtung auf, die ein Netzmodell 20 des zweiten Teilnetzes aufweist. In diesem Netzmodell 20 werden über Datenkommunikationsverbindungen 15,16,17,18 die Netzmodelle 19 der die jeweiligen Teilnetze 4,12,13,14 kontrollierten ersten Steuereinrichtungen 1 berücksichtigt. Es entsteht ein integriertes Netzmodell 20, das "bottom up" von der Niederspannungsebene aus mit Daten versorgt und aktuell gehalten wird. Es werden Messwerte P,Q,U,I von Messeinrichtungen im zweiten Teilnetz 6 über Datenkommunikationspfade 23 eingespielt und ausgewertet.

Das Teilnetz 6 umfasst als Hochspannungsnetz eine Vielzahl von Mittelspannungsnetzen, auch das Teilnetz 5. Es weist eine zentrale Leitstelle 3 als dritte Steuereinrichtung auf, die ein Netzmodell 21 des dritten Teilnetzes aufweist. In diesem Fall mit drei Teilnetzen 4,5,6 stellt die Steuereinrichtung 2 des Teilnetzes 5 der Mittelspannungsebene aus Sicht des Leistelle 3 eine erste Steuereinrichtung dar, und die Leitstelle wird im Sinne der Erfindung zur zweiten Steuereinrichtung aus Sicht des Feldgeräts 2. Das Netzmodell 21 berücksichtigt die aus den untergeordneten Teilnetzen 4,5 zugelieferten Netzmodelle 19,20. Auf diese Weise sind alle Netzmodelle 19,20,21 konsistent und widerspruchsfrei automatisiert ausgebildet worden.

## Patentansprüche

1. Anordnung zur Steuerung eines elektrischen Energienetzes mit zwei Teilnetzen (4,5),
mit einer ersten Steuereinrichtung (1) für ein erstes Teilnetz (4), die ausgebildet ist, anhand eines Netzmodells (19) des ersten Teilnetzes (4) eine erste Zustandsschätzung für das erste Teilnetz (4) zu erstellen, um anhand der ersten Zustandsschätzung Steuerbefehle an steuerbare Betriebsmittel des ersten Teilnetzes (4) zu erstellen und zu senden, so dass ein erstes Steuerungsziel im ersten Teilnetz (4) erreicht wird, und
mit einer zweiten Steuereinrichtung (2) für ein zweites Teilnetz (5), die ausgebildet ist, anhand eines Netzmodells (20) des zweiten Teilnetzes (5) eine zweite Zustandsschätzung für das zweite Teilnetz (5) zu erstellen, um mittels der zweiten Zustandsschätzung Steuerbefehle an steuerbare Betriebsmittel des zweiten Teilnetzes (5) zu erstellen und zu senden, so dass ein zweites Steuerungsziel im zweiten Teilnetz (5) erreicht wird,
**dadurch gekennzeichnet, dass**
die erste Steuereinrichtung (1) ausgebildet ist, mittels einer ersten Kommunikationseinrichtung ein Datentelegramm mit dem ersten Netzmodell (19) über eine Datenkommunikationsverbindung an die zweite Steuereinrichtung (2) zu senden,
und dass
die zweite Steuereinrichtung (2) ausgebildet ist, mittels einer zweiten Kommunikationseinrichtung das Datentelegramm zu empfangen und das erste Netzmodell (19) in das zweite Netzmodell (20) zu integrieren.

2. Anordnung nach Anspruch 1, **dadurch gekennzeichnet, dass** die zwei Teilnetze die gleiche Nennspannung aufweisen.

3. Anordnung nach Anspruch 1, **dadurch gekennzeichnet, dass** die zwei Teilnetze unterschiedliche Nennspannungen (4,5,6) aufweisen.

4. Anordnung nach einem der vorhergehenden Ansprüche, **dadurch gekennzeichnet, dass** die erste und/oder die zweite Steuereinrichtung (1,2) als ein Feldgerät, Remote Terminal Unit, Schutzgerät oder Microgrid-Controller ausgebildet sind.

5. Anordnung nach einem der vorhergehenden Ansprüche, **dadurch gekennzeichnet, dass** das Netzmodell (19) des ersten Teilnetzes (4) eine Admittanzmatrix aufweist, die anhand von Impedanzwerten für Leitungen im ersten Teilnetz (4) ermittelt ist.

6. Anordnung nach Anspruch 5, **dadurch gekennzeichnet, dass** die Admittanzmatrix anhand einer Topologieinformation mit Leitungen (10) und Knotenpunkten erstellt ist.

7. Anordnung nach einem der vorhergehenden Ansprüche, **dadurch gekennzeichnet, dass** für die erste Zustandsschätzung Messwerte (P,Q,U,I) von Messeinrichtungen im ersten Teilnetz berücksichtigt sind.

8. Anordnung nach Anspruch 7, **dadurch gekennzeichnet, dass** die Messwerte mindestens eine der folgenden elektrischen Messgrößen beschreiben: Spannung (U), Stromstärke (I), elektrische Leistung (P), elektrische Blindleistung (Q), Phasenwinkel.

9. Anordnung nach einem der vorhergehenden Ansprüche, **dadurch gekennzeichnet, dass** die erste und/oder die zweite Steuereinrichtung (1,2) ausgebildet sind, anhand der jeweiligen Zustandsschätzung mittels einer jeweiligen Optimierungseinrichtung Steuerbefehle an steuerbare Betriebsmittel des jeweiligen Teilnetzes (4,5) zu erstellen und zu senden, so dass elektrische Verluste minimiert werden.

10. Verfahren zur Steuerung eines elektrischen Energienetzes mit zwei Teilnetzen (4,5), bei dem
mittels einer ersten Steuereinrichtung (1) für ein erstes Teilnetz (4) anhand eines Netzmodells (19) des ersten Teilnetzes (4) eine erste Zustandsschätzung für das erste Teilnetz (4) erstellt wird, und anhand der ersten Zustandsschätzung Steuerbefehle an steuerbare Betriebsmittel des ersten Teilnetzes (4) erstellt und gesendet werden, so dass ein erstes Steuerungsziel im ersten Teilnetz (4) erreicht wird, und bei dem
mittels einer zweiten Steuereinrichtung für ein zweites Teilnetz (5) anhand eines Netzmodells des zweiten Teilnetzes (5) eine zweite Zustandsschätzung für das zweite Teilnetz (5) erstellt wird,
und anhand der zweiten Zustandsschätzung Steuerbefehle an steuerbare Betriebsmittel des zweiten Teilnetzes (5) erstellt und gesendet werden, so dass ein zweites Steuerungsziel im zweiten Teilnetz (5) erreicht wird,
**dadurch gekennzeichnet, dass**
mittels der ersten Steuereinrichtung (1) mittels einer ersten Kommunikationseinrichtung ein Datentelegramm mit dem ersten Netzmodell (19) über eine Datenkommunikationsverbindung an die zweite Steuereinrichtung (2) gesendet wird,
und dass
mittels der zweiten Steuereinrichtung (2) mittels einer zweiten Kommunikationseinrichtung das Datentelegramm empfangen und das erste Netzmodell (19) in das zweite Netzmodell (20) integriert wird.

11. Verfahren nach Anspruch 10, **dadurch gekennzeichnet, dass** für die zwei Teilnetze die gleiche Nennspannung verwendet wird.

12. Verfahren nach Anspruch 10, **dadurch gekennzeichnet, dass** für die zwei Teilnetze (4,5) unterschiedliche Nennspannungen verwendet werden.

13. Verfahren nach einem der Ansprüche 10 bis 12, **dadurch gekennzeichnet, dass** für die erste und/oder die zweite Steuereinrichtung (1,2) ein Feldgerät, eine Remote Terminal Unit, ein Schutzgerät oder ein Microgrid-Controller verwendet werden.

14. Verfahren nach einem der Ansprüche 10 bis 13, **dadurch gekennzeichnet, dass** für das Netzmodell (19) des ersten Teilnetzes (4) eine Admittanzmatrix verwendet wird, die anhand von Impedanzwerten für Leitungen im ersten Teilnetz (4) ermittelt ist.

15. Verfahren nach Anspruch 14, **dadurch gekennzeichnet, dass** die Admittanzmatrix anhand einer Topologieinformation mit Leitungen (10) und Knotenpunkten erstellt wird.
